# DEMANDE DE BREVET EUROPEEN

(11) **EP 1 621 516 A1**
(43) Date de publication de la demande: **01.02.2006**
(21) Numéro de dépôt: 05106846.8
(22) Date de dépôt: 26.07.2005
(51) Int. Cl.: B81C 3/00

(54) **Dispositif microtechnologique comportant des structures assemblées magnétiquement et procédé d'assemblage**

(30) Priorité: 28.07.2004 FR 0451688
(71) Demandeur: COMMISSARIAT A L'ENERGIE ATOMIQUE, 75752 Paris Cédex 15 (FR)
(72) Inventeur: Kopp, Christophe, 38120 Le Fontanil Cornillon (FR)
(74) Mandataire: Poulin, Gérard

(57) **Abrégé**

Un procédé d'assemblage de différents éléments (32, 40) composant un dispositif microtechnologique (30) est décrit. Le procédé d'assemblage comporte une fixation des deux éléments (32, 40) l'un à l'autre par interaction magnétique de moyens (34, 42) qui sont réalisés dans les éléments (32, 40). De préférence, l'assemblage et la fixation s'accompagnent d'un alignement des éléments (32, 40) grâce à l'interaction magnétique entre les moyens (34, 42). L'alignement peut être passif, ou dynamique, notamment grâce à la présence d'une matrice d'électroaimants (36) dans un des moyens au moins.

## Description

### DOMAINE TECHNIQUE

L'invention concerne l'assemblage et la fixation des dispositifs miniatures, issus notamment de la microtechnologie. L'invention trouve une application particulière pour l'alignement des différents composants optiques, électriques, mécaniques ou optoélectroniques.

### ÉTAT DE LA TECHNIQUE ANTÉRIEURE

Les différents constituants d'un dispositif sont généralement assemblés sur un support ou un substrat par les techniques de serrage mécanique, collage ou brasage. L'application de ces trois procédés aux composants miniatures issus de la microtechnologie, qu'ils soient optiques, électroniques ou mécaniques, présente plusieurs inconvénients.

Le collage par exemple est une technique largement appliquée, notamment avec des colles photoréticulables, car cette technique permet d'aligner les composants avant de les fixer. Cependant, ce procédé peut amener une réduction de la fiabilité des composants par l'intervention d'un composé exogène : par exemple, le dégazage de la colle, et en particulier d'une résine de type époxy, à proximité d'une diode laser est critique à cause de la condensation qui risque de se déposer sur la surface émettrice de la source optique.

Le brasage est également largement appliqué ; il permet notamment l'autoalignement de composants grâce à la technique dite du « flip-chip » : des billes fusibles sont localisées sur des matrices de zones métallisées, et soumises à une élévation de température. La tension de surface des billes en fusion entraîne la superposition des matrices des zones métallisées respectivement réalisées sur le composant et sur son support. En revanche, le brasage nécessite l'utilisation de flux liquides ou gazeux qui peuvent également introduire une réduction de la fiabilité des composants. De plus, le brasage nécessite de chauffer le dispositif au dessus de 100°C, ce qui peut également altérer certains composants.

Le serrage mécanique n'altère pas les composants microtechnologiques dans leur nature. Par contre, il nécessite l'introduction de composants volumineux supplémentaires qui viennent encombrer le support du dispositif. Or cette interposition n'est pas toujours possible, en particulier lorsque différents composants doivent être placés à proximité les uns des autres. De plus, la mise en oeuvre de ce type d'assemblage ne permet pas, lors du serrage, de garantir le respect avec précision d'un alignement préalable.

Pour aider à l'alignement, le document U5-A-6 049 947 propose un outillage adapté comprenant des aimants. Cependant, cette structure est longue et lourde à mettre en oeuvre.

### EXPOSÉ DE L'INVENTION

L'invention se propose donc de trouver un procédé permettant d'assembler, d'aligner (ou d'auto aligner) et de fixer des composants miniatures issus de la microtechnologie sans les inconvénients des techniques connues.

Sous l'un de ses aspects, l'invention concerne un dispositif microtechnologique comprenant plusieurs éléments assemblés et solidarisés entre eux par l'interaction magnétique de moyens, ou structures, qu'ils comprennent. Grâce à ce choix de fixation, il est possible d'aligner les éléments l'un avec l'autre, tout en n'altérant pas leurs propriétés lors de leur solidarisation.

Les éléments peuvent comprendre les différents composants connus de microtechnologie, et notamment l'un des éléments peut être un substrat qui est solidarisé à une plaque de composant ou à un composant ou plusieurs composants différents.

Il est possible également de solidariser entre eux différents composants. Par composant, il faut comprendre les lentilles, puces laser, émetteurs, composants mécaniques tels que supports de fibre optique ou optoélectroniques par exemple.

Les moyens d'interaction magnétique peuvent comprendre des matériaux magnétisables, des alliages aimantés ou des électroaimants. Il peut s'agir de structures localisées à la surface des éléments qu'elles solidarisent, par exemple par dépôt ou par report de composés individuels. Les moyens pour l'interaction magnétique peuvent être de nature identique ou complémentaire, que ce soit pour la forme et la nature de leurs constituants, ou pour leur géométrie générale.

De préférence, les moyens comprennent des matrices de plusieurs composés susceptibles de générer un champ magnétique de façon à permettre un alignement précis. Il est possible que les matrices soient superposables ; selon un autre mode de réalisation, une structure comprend en outre une deuxième matrice d'électroaimants de façon à permettre un alignement dynamique.

L'invention concerne également un procédé d'assemblage par interaction magnétique d'éléments d'un dispositif microtechnologique. De préférence, l'assemblage est accompagné par un alignement, passif ou dynamique, des éléments.

Avantageusement, l'étape d'assemblage par interaction magnétique est précédée d'une étape de formation de moyens magnétisables ou aimantés sur les éléments. La formation des moyens magnétiques peut être effectuée par dépôt de couches d'alliages aimantés ou de couches d'électroaimants, ou par report de composés individuels.

### BRÈVE DESCRIPTION DES DESSINS

Les figures annexées permettront de mieux comprendre l'invention, mais ne sont données qu'à titre indicatif et ne sont nullement restrictives.

Les figures 1A, 1B, 1C et 1D présentent des dispositifs selon l'invention, les deux éléments étant séparés.

La figure 2 montre une configuration de moyens magnétiques pour un dispositif selon un mode de réalisation de l'invention permettant un alignement dynamique.

La figure 3 montre un autre mode de réalisation d'un dispositif selon l'invention.

### EXPOSÉ DÉTAILLÉ DE MODES DE RÉALISATION PARTICULIERS

L'invention propose d'aligner et de fixer les composants à assembler, par exemple sur un support, grâce à l'interaction magnétique entre des moyens magnétisables qui sont compris dans chacun des éléments à assembler.

En effet, certaines techniques rendent possible l'intégration aux éléments à assembler de moyens susceptibles de générer un champ magnétique suffisamment puissant pour solidariser ces éléments. Par ailleurs, les structures ainsi créées gardent une taille compatible avec la microtechnologie.

Ainsi, selon un mode préféré de l'invention, sur un substrat, ou tout autre composant électronique, ou optique, ou optoélectronique, ou micromécanique, ou autre classique en microtechnologie, une zone aimantée, ou magnétisable, ou comprenant des électroaimants, est réalisée, de préférence en surface de façon à améliorer l'alignement. La réalisation peut être effectuée par report de composés unitaires ou par dépôt d'une couche de matériau et technique lithographique d'usinage, par exemple par gravure, sur un substrat :
1) Des composés unitaires sont par exemple usinés dans des alliages métalliques de type samarium-cobalt ou aluminium-nickel-cobalt ou néodyme-fer-bore : ces métaux sont dits magnétiques car une fois soumis à un champ magnétique, ils restent fortement aimantés. Les composés sont fabriqués sous la forme adéquate (disques, plaquettes carrées, barrettes allongées,...), puis positionnés sur l'élément à solidariser, si possible selon une géométrie régulière. Ils y sont fixés selon des techniques classiques, par exemple par collage, par adhésion moléculaire, par thermo compression, par brasage, par soudage par laser, ou par faisceau d'électrons.
2) Des électro-aimants unitaires sont par exemple réalisés par bobinage de fil de cuivre très fin (dont le diamètre typique est de l'ordre de 50 µm). Ces composés pourront être reportés sur un substrat, de type circuit imprimé ou céramique métallisée, afin de connecter les électro-aimants au système de commande via des pistes électriques. La même mise en place que pour l'exemple 1 ci-dessus peut être réalisée.
3) Des matériaux magnétiques de type cobalt-platine ou cobalt-platine-phosphore ou nickel-fer peuvent par ailleurs être mis en place directement sur l'élément à solidariser par dépôt électrolytique ou dépôt plasma en phase vapeur (PVD). Les zones aimantées ainsi réalisées peuvent être structurées géométriquement par les techniques lithographiques issues de la microélectronique, par exemple par gravure. Ce type de procédé permet de générer des épaisseurs de plusieurs micromètres.
4) Il est possible également de déposer sur une surface de composant microtechnologique des résines chargées en poudre de matériaux magnétiques, afin de réaliser des motifs de plusieurs dizaines de micromètres d'épaisseur (voir par exemple Cho HJ et Ahn CH : « Microscale resin-bonded permanent magnets for magnetic micro-electro-mechanical systems applications », *Journal of Applied Physics* 2003 ; 93(10) : 8674-76).
5) Un dépôt d'électroaimants en multicouche peut être réalisé par technique lithographique de façon à obtenir une forme proche de la bobine avec un matériau tel que le cuivre. Dans cette configuration, les pistes électriques connectant les électro-aimants au système de commande sont généralement réalisées sur le substrat par les mêmes techniques.
6) D'autres procédés sont envisageables pour augmenter l'épaisseur des « micro aimants » si cela est préféré. Par exemple le dépôt par laser pulsé du Nd-Fe-B permet d'atteindre des épaisseurs de l'ordre de 40 à 50 µm (Nakano M et coll. : « Fabrication of Nd-Fe-B thick film magnets by high speed PLD method », *IEEE Transaction on Magnetics* 2003 ; 39(5) : 2863-65).

Ces différents procédés de réalisation permettent d'obtenir des zones susceptibles de créer des champs magnétiques de taille réduite, mais dont la puissance est suffisante pour maintenir en place un composant microtechnologique. En particulier, les aimants obtenus par technique de report (1 et 2) peuvent avoir classiquement une surface de l'ordre de 1 mm² pour une hauteur de 0,5 mm, et peuvent aisément être mis en place avec un pas de l'ordre du mm. En ce qui concerne les technologies microélectroniques, on peut avoir des aimants de surface inférieure à 0,5 x 0,5 mm² pour une hauteur de 5 à 50 µm, avec un pas de 100 µm par exemple.

Ainsi par exemple, un dépôt électrolytique CoPt permet la réalisation d'un aimant d'environ 100 µm² sur 5 µm d'épaisseur, générant une force de l'ordre de quelques N, soit plusieurs mg/mm². Une telle force est suffisante pour des composants miniatures : typiquement un morceau de silicium de 1 mm² sur 0,5 mm d'épaisseur pèse environ 1 mg.

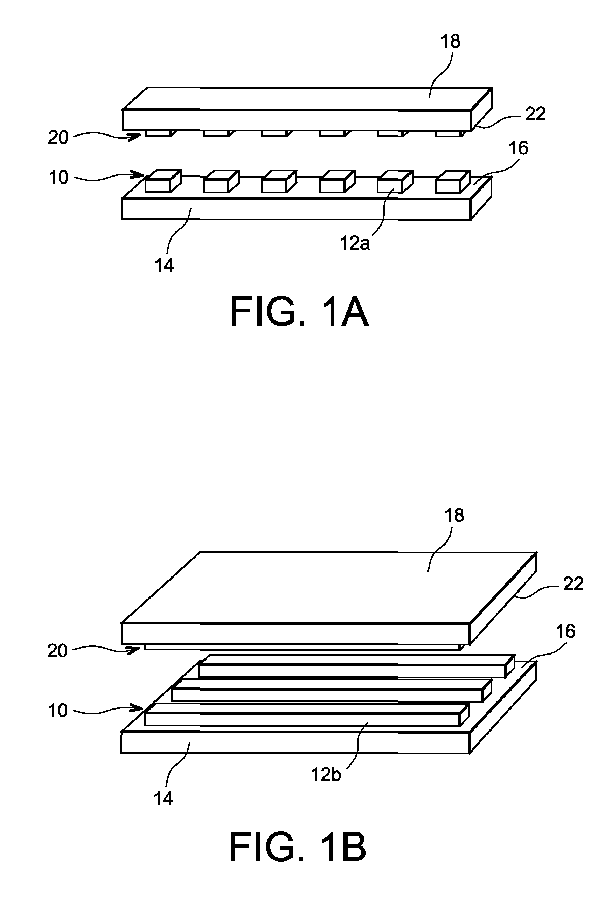

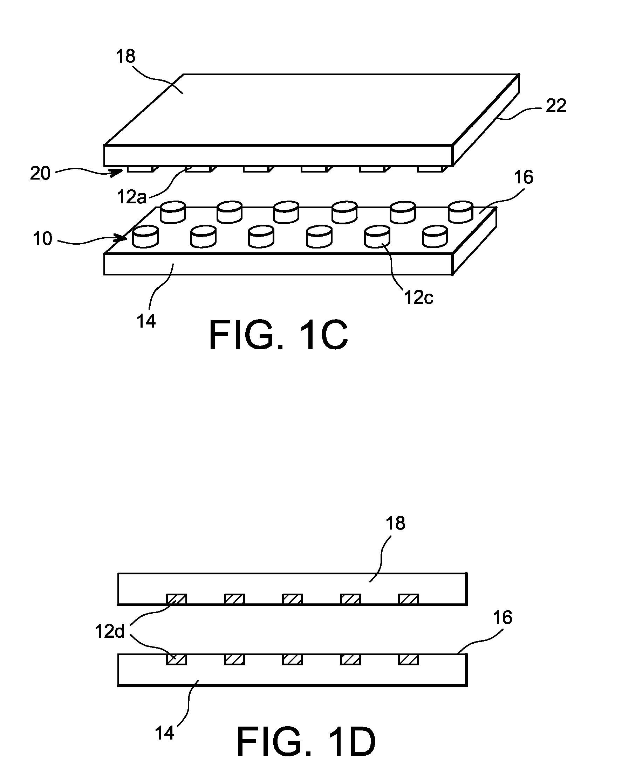

De préférence, les zones ainsi créées forment des moyens magnétiques, ou des structures, qui se présentent sous la forme de matrices, comme schématisé en figure 1. En particulier, les matrices 10 peuvent être composées d'une barrette d'aimants carrés 12a (figure 1A), ou d'un alignement de bandes parallèles 12b traversant le support 14 (figure 1B), ou d'un quadrillage régulier par des aimants ronds 12c de la surface 16 d'un élément 14 à solidariser (figure 1C). Les aimants peuvent être en surface, ou « enterrés » comme sur la figure 1D, c'est-à-dire que les aimants 12d peuvent être enchâssés dans le support 14, avec leur surface de niveau avec la surface 16 du support.

De façon préférée, lorsqu'un composant 18 est prévu pour être solidarisé sur un substrat 14, les moyens magnétiques 10, 20 de chacun peuvent être composés de matrices superposables mais polarisées inversement de façon à s'attirer entre-elles, comme schématisé sur les figures 1A et 1B.

Lors de l'assemblage des deux éléments 14, 18, après un réglage grossier permettant de superposer approximativement les matrices 10, 20, les surfaces 16, 22 à mettre en contact sont approchées de façon suffisante pour permettre aux forces magnétiques générées de positionner plus précisément les matrices 10, 20 et ainsi de générer l'auto alignement du composant 18 sur le substrat 14. L'ajustement peut ainsi être supérieur à 1 µm. Ensuite, les surfaces 16, 22 sont mises en contact afin de maximiser les forces d'attraction magnétique et ainsi maintenir le composant 18 et conserver l'alignement.

Il est clair que sur les figures, les dimensions ne sont pas à l'échelle en ce qui concerne les épaisseurs des aimants. De plus, selon l'application, les éléments seront en relief sur la surface de l'élément, ou enterrés (figure 1D) pour affleurer la surface 16, et ainsi pouvoir ajuster le jeu entre les éléments 14, 18.

La géométrie des composés magnétiques 12 des matrices 10, 20 peut être identique, mais elle peut également être légèrement différente selon les contraintes d'encombrement sur les faces à assembler : voir par exemple figure 1C. On peut ainsi superposer une matrice 10 d'aimants ronds 12c sur une matrice 20 d'aimants carrés 12a. Il est possible également de choisir des géométries complémentaires de façon à améliorer la capacité d'auto alignement, par exemple avec un aimant annulaire sur l'un des composants.

Il est entendu que dans ces exemples, le terme « composé magnétique » recouvre non seulement des aimants, mais également les différentes possibilités décrites plus haut. En particulier, une ou les deux matrices 10, 20 peuvent être constituées, entièrement ou partiellement, d'électroaimants, ce qui permet de commander électriquement l'activation des forces d'attraction magnétique.

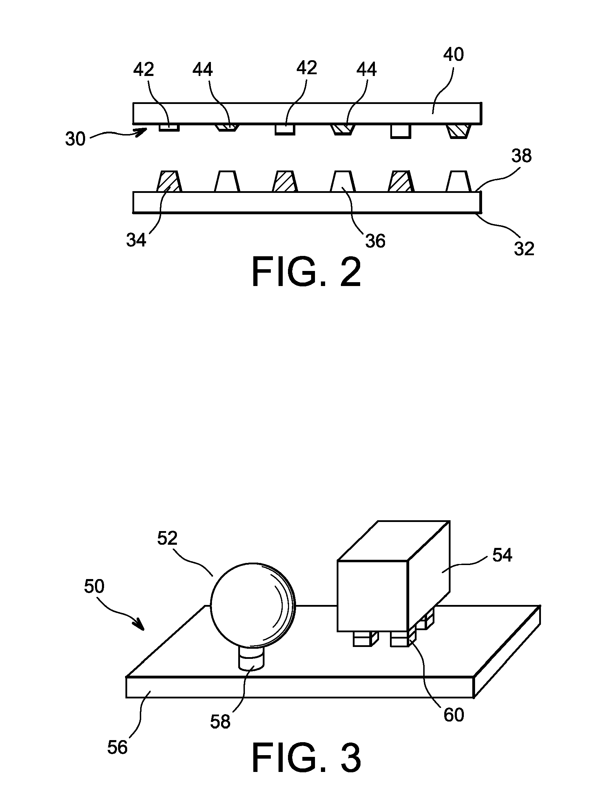

Un exemple particulier de ce type de configuration est donné dans le dispositif 30 représenté en figure 2. Un composant 32, avantageusement sous forme de plaque, par exemple le substrat, comporte une première matrice d'électroaimants 34. Une matrice 36 décalée sur la surface 38 à mettre en contact est prévue. Ceci permet de réaliser un alignement dynamique commandé électriquement pendant ou après la dépose du composant 40 sur le substrat 32 en activant l'une ou l'autre des matrices 34, 36 d'électro-aimants. Ainsi, la position du composant 40 sur le substrat 32 peut être corrigée pendant, ou également après, la dépose.

La figure 2 montre en outre la présence additionnelle, mais non nécessaire, de deux jeux d'aimants 42, 44 sur le composant 40 : il est en effet possible de jouer sur les deux éléments 32, 40 à solidariser, ou de prévoir deux possibilités d'alignements différents.

Pour un tel alignement dynamique, il est également possible de combiner les natures des moyens magnétiques, et de réaliser un système mixte d'alignement passif et actif de façon à permettre des corrections fines de positionnement, en remplaçant par exemple l'une des matrices d'électroaimants 34, 36 ou 42, 44 par une matrice de composés aimantés.

Les techniques de positionnement et d'assemblage décrites peuvent être appliquées à toute sorte de composants : on peut associer, au substrat ou entre eux, des composants optiques tels que puces micro laser, lentilles, émetteurs, ou des composants mécaniques comme des supports de fibre optique, voire des composants optoélectroniques avec les matrices de détecteurs.

Il est possible aussi, en combinant la géométrie des aimants, d'assembler des composés de natures différentes sur un même support : voir le dispositif 50 de la figure 3 qui présente l'assemblage d'une lentille 52 et d'une puce laser 54 sur un même substrat 56 au moyen de moyens aimantés présentant des matrices 58, 60 différentes.

Par exemple, les composés suivants ont pu être fixés par le procédé selon l'invention : microlentille sphérique de diamètre 500 µm, puce microlaser de 1 mm³, micro-miroirs et micro-prismes de largeur 1 mm, source laser de type diode de 1 mm x 200 µm, source laser de type VECSEL de 0,5 mm²,... De même, il a été possible de positionner de façon fixe une plaque de composant (en particulier de type substrat de silicium utilisé en microélectronique) de 1 à 30 cm de côté pour une épaisseur de 500 µm. Pour ces différentes réalisations, les matrices d'aimants avaient des pas pouvant aller de 100 µm à 1 mm.

Le procédé d'alignement et d'assemblage selon l'invention présente, entre autres, les avantages suivants :
- la fixation des composants grâce aux forces magnétiques, contrairement au collage et au brasage, ne nécessite aucune application de flux liquide ou gazeux, aucune montée en température, et ne génère aucun risque de dégazage qui pourrait réduire la fiabilité des composants ;
- il est possible d'auto aligner le composant sur le support, à la manière d'un « flip-chip » magnétique ;
- l'activation des forces magnétiques peut être effectuée à la demande et avec retard, par commande électrique ;
- un alignement dynamique du composant sur le support et une correction de la position du composant sur le support sont possibles ;
- la conduction thermique et électrique au sein du dispositif microtechnologique est améliorée grâce au contact métal/métal par les moyens susceptibles de produire un champ magnétique ;
- il est possible de positionner avec précision et de fixer plusieurs composants sur un même substrat.

## Revendications

1. Dispositif microtechnologique comprenant au moins deux éléments (14, 18 ; 32, 40), chacun des éléments comprenant des moyens pour produire un champ magnétique (10, 20 ; 34, 42), dans lequel les éléments sont solidarisés l'un à l'autre directement par l'interaction magnétique entre leurs moyens.

2. Dispositif selon la revendication 1 dans lequel les moyens (10, 20 ; 34, 42) d'un élément au moins sont localisés à la surface de cet élément (14, 18 ; 32, 40) qui est en contact avec un autre élément auquel il est solidarisé.

3. Dispositif selon la revendication 2 dans lequel chacun des moyens (10, 20 ; 34, 42) est localisé sur une surface de l'élément (14, 18 ; 32, 40) correspondant qui est en contact avec un autre élément auquel il est solidarisé.

4. Dispositif selon l'une des revendications 1 à 3 dans lequel les moyens pour produire un champ magnétique (10, 20 ; 34, 42) comprennent au moins un matériau aimantable.

5. Dispositif selon la revendication 4 dans lequel le matériau aimantable est un alliage métallique magnétique de type samarium-cobalt, aluminium-nickel-cobalt, néodyme-fer-bore, cobalt-platine-phosphore, cobalt-platine ou nickel-fer.

6. Dispositif selon l'une des revendications 1 à 5 dans lequel les moyens pour produire un champ magnétique (10, 20 ; 34, 42) comprennent un électroaimant.

7. Dispositif selon l'une des revendications 1 à 6 dans lequel un premier élément (14, 18 ; 32, 40) comprend des premiers moyens comprenant une première matrice (10, 20 ; 34, 42) de composés (12) susceptibles de produire un champ magnétique.

8. Dispositif selon la revendication 7 dans lequel un deuxième élément (14, 18 ; 32, 40) comprend des deuxièmes moyens comprenant une deuxième matrice (10, 20 ; 34, 42) de composés (12) susceptibles de produire un champ magnétique.

9. Dispositif selon la revendication 8 dans lequel la première matrice et la deuxième matrice sont superposables.

10. Dispositif selon l'une des revendications 8 à 9 dans lequel les deuxièmes moyens (14, 18 ; 32, 40) comprennent une troisième matrice (36, 44).

11. Dispositif selon l'une des revendications 1 à 10 dans lequel un élément comprend une plaque de substrat (14, 32, 56).

12. Dispositif selon la revendication 11 dans lequel un élément solidarisé à la plaque de substrat (56) comprend une pluralité de composants microtechnologiques (52, 54) différents.

13. Dispositif selon la revendication 11 dans lequel un élément solidarisé à la plaque de substrat (16, 32) comprend une plaque de composant microtechnologique (18, 40) superposable au premier élément.

14. Procédé d'assemblage d'un dispositif microtechnologique comprenant deux éléments (14, 18 ; 32, 40 ; 56, 52, 54), dans lequel des moyens pour produire un champ magnétique sont réalisés dans chaque élément, et les deux éléments sont assemblés par interaction magnétique des moyens.

15. Procédé d'assemblage selon la revendication 14 dans lequel un élément (14, 18 ; 32, 40 ; 56) a une surface plane et les moyens y sont réalisés par dépôt de matériau magnétique.

16. Procédé d'assemblage selon l'une des revendications 14 à 15 dans lequel un élément (14, 18 ; 32, 40 ; 56) a une surface plane et les moyens y sont réalisés par dépôt de multicouche d'électroaimant.

17. Procédé d'assemblage selon l'une des revendications 14 à 16 dans lequel des moyens sont réalisés par report de composants magnétiques et/ou d'électroaimants sur l'élément (14, 18 ; 32, 40 ; 52, 54, 56).

18. Procédé d'assemblage selon l'une des revendications 14 à 17 dans lequel les premiers moyens d'un premier élément (32) comprennent une première matrice (34) de composés et les deuxièmes moyens d'un deuxième élément (40) comprennent une deuxième matrice (42) de composés, la première et la deuxième matrices (34, 42) étant superposables.

19. Procédé d'assemblage selon la revendication 18 dans lequel les premiers moyens comprennent une troisième matrice (36) de composés superposable à la deuxième matrice (42).

20. Procédé d'assemblage selon l'une des revendications 18 à 19 comprenant en outre l'alignement des deux éléments (32, 40) par interaction de la première matrice (34) avec la deuxième matrice (42).

21. Procédé d'assemblage selon la revendication 19 dans lequel les composés d'une des première et troisième matrices (34, 36) sont des électroaimants et comprenant un alignement dynamique des éléments (32, 40) par commande des électroaimants.
